(19) Europäisches Patentamt
European Patent Office
Office européen des brevets

(11) **EP 3 742 183 A1**

(12) **EUROPEAN PATENT APPLICATION**

(43) Date of publication:
**25.11.2020 Bulletin 2020/48**

(51) Int Cl.:
***G01R 33/54*** *(2006.01)*

(21) Application number: **19175285.6**

(22) Date of filing: **20.05.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Koninklijke Philips N.V.**
**5656 AG Eindhoven (NL)**

(72) Inventor: **MAHESH, Chandana**
**5656 AE Eindhoven (NL)**

(74) Representative: **de Haan, Poul Erik et al**
**Philips International B.V.**
**Philips Intellectual Property & Standards**
**High Tech Campus 5**
**5656 AE Eindhoven (NL)**

(54) **A CONTROL SYSTEM FOR A MAGNETIC RESONANCE IMAGING SYSTEM**

(57) The present disclosure relates to a control system (111) for a magnetic resonance imaging, MRI, system (700). The control system (111) comprises at least one processor (103) and at least one memory (107) comprising computer program code (121), wherein execution of the computer program code (121) by the processor (103) causes the control system (111) to at least perform: determining current values of a set of acquisition parameters of a current setting of the MRI system (700); evaluating a performance parameter of the MRI system using the current setting, the evaluation resulting in a current value of the performance parameter; comparing the value of the performance parameter with a reference value of the performance parameter, the reference value of the performance parameter being provided for reference values of the set of acquisition parameters of a reference setting; controlling the MRI system to acquire MRI data in accordance with a received selection one of the current setting and the reference setting.

Fig. 3C

**Description**

FIELD OF THE INVENTION

The invention relates to scanning imaging systems, in particular to a control system for a magnetic resonance imaging (MRI) system.

BACKGROUND OF THE INVENTION

A MR scanner is a complex system with more than 800 acquisition parameters that could be modified for scanning. Many a times, the operators modify these parameters depending for example, on the patient condition and hospital's need. However, an inappropriate modification of these parameters could instead lead to sub-optimal performances.

SUMMARY OF THE INVENTION

Various embodiments provide for a control system for an MRI system, method, and computer program product, as described by the subject matter of the independent claims. Advantageous embodiments are described in the dependent claims.

Application specialists spend considerable effort in customizing and baselining MRI protocols for each hospital based on its need. Despite that, in most cases, the operators further modify the baselined (or reference) protocols due to various reasons while performing scans. An inappropriate modification of protocol parameters could lead to sub-optimal image quality or increase in scan time. Many times, the operators may not be well-trained and hence may not comprehend the overall impact that the drift or change would have on performance parameters such as the impact on both scan time and image quality. This may lead to re-scans e.g. when the expected image quality is not achieved. Moreover, unnecessary parameter modifications may unnecessarily add to patient scan time, and hence increase the overall scan time per patient. For that, the present subject matter may provide a control system such as a protocol management system for a magnetic resonance examination system. The control system may be configured to select an acquisition protocol and set parameters of the protocol. The control system, upon user input of the selection and settings, may return an estimate of scan duration to acquire the magnetic resonance signals and of expected image quality. This may provide better insight in the effects of protocol changes and is effective in more efficient selection and parameter setting for controlling the MRI system.

In one aspect, the invention relates to a control system for a magnetic resonance imaging, MRI, system. The control system comprises at least one processor and at least one memory comprising computer program code, wherein execution of the computer program code by the processor causes the control system to at least perform:

a) determining current values of a set of acquisition parameters of a current setting of the MRI system;
b) evaluating a performance parameter of the MRI system using the current setting, the evaluation resulting in a current value of the performance parameter;
c) comparing the value of the performance parameter with a reference value of the performance parameter, the reference value of the performance parameter being provided for reference values of the set of acquisition parameters of a reference setting;
d) providing data indicative of the current setting and indicative of a comparison between the current value and the reference value of the performance parameter on a user interface and further providing on the user interface data indicative of the reference setting;
e) in case of receiving a selection of one of the settings, controlling the MRI system to acquire MRI data in accordance with the received selection; otherwise and in case of receiving a change in the current setting repeating steps a) to e).

The MRI system may enable to acquire MRI data in accordance with open one or more imaging protocols. The imaging protocol or protocol refers to a set of technical settings or set of acquisition parameters of imaging modalities to produce the images (e.g. MR images) required for an examination. For example, an acquisition parameter may indicate a pulse sequence type. The values of the set of acquisition parameters may be referred to (or named) as setting (the setting may thus indicate or refer to a protocol). E.g. the current setting refers to the current values of the set of acquisition parameters and the reference setting refers to the reference values of the set of acquisition parameters. The reference values of the set of acquisition parameters may be values of the set of acquisition parameters of a reference or a baselined protocol for the exam being done. The set of acquisition parameters may have initial values before executing steps a) to e). This may define an initial setting. In one example, the initial setting may be the reference setting.

Step d) may provide on the user interface in each iteration data indicative of all settings that result from the executions of step a), in addition to the comparisons of the values of the performance parameter with the reference value.

The user interface may be a user interface of the control system or a user interface of the MRI system. The user interface may be displayed on a display system of the control system or of the MRI system. The display system may comprise one or more screens. The user interface may be displayed in one of the screens of the display system.

The execution of the method may result in one or more settings that are defined by the respective values of the set of acquisition parameters as determined in step a) in addition to the reference setting. For example, if steps a) to e) are executed two times before controlling the MRI system, then two settings (result of the two executions of step a)) in addition to the reference settings exist. The controlling of the MRI system comprises performing a scan by the MRI system. Also, two values of the performance parameters of the two settings in addition to the reference value exist. In this case, step e) may receive a selection of one of the three settings and step d) may provide data indicative of the three settings and indicative of the comparison between the two values of the performance parameter and the reference value.

In one example, after controlling the MRI system to acquire data in accordance with the received selection, the method steps a) to e) may be repeated in order to acquire further MRI data. Following the above example, if steps a) to e) are executed two times before controlling the MRI system to acquire MRI data, steps a) to e) may further be executed e.g. 3 times before the MRI system to acquire further MRI data. In this case, step d) may provide in the last execution step data indicative of the five settings and the reference setting and also the comparisons of the five values of the performance parameters with the reference value.

The control system may for example be remotely connected to the MRI system. This may enable a standalone or independent implementation of the control system. This may enable a centralized approach in which the control system may control multiple MRI systems in accordance with the present subject matter e.g. step e) may be performed for controlling multiple MRI systems to acquire data with one of the selected settings.

The present subject matter may enable an optimal control of MRI systems for acquiring MRI data. The user of the MRI system may be guided to react and decide on the data acquisition as quickly as possible. This may particularly be advantageous in emergency situations where some patients may need immediate intervention that relies on the acquired MRI data. E.g. instead of spending few minutes to decide to do the scanning, the operator may spend longer time if for example the provided information is distributed over multiple screens and/or the comparison between the values is to be made by the operator himself or herself. Also, getting a scan first-time-right and avoiding re-scans may be advantageous in case of patients with claustrophobia or younger children who are unable to stay still for a longer time.

According to one embodiment, steps a) -e) are executed during operation of the MRI system. This may enable a real-time continued and/or guided human-machine interaction process interaction with the MRI system which may assist the operator in performing the acquisition of MRI data or scanning. In this case the scanning may be performed in an efficient manner.

According to one embodiment, execution of the computer program code by the processor further causes the control system to: retrieve from a database the reference value; compute the difference between values of the performance parameter of the current setting and the reference setting; wherein the providing of the comparison comprises displaying the computed difference. The reference value may provide a single reference point for multiple executions of the steps a) to e) by the control system e.g. for different patients. This may enable a consistent and accurate acquisition of MRI data. The comparing may be quantified by the difference as describe in this embodiment. In another example, the comparison may be quantified by relative difference (percent) of the current value and the reference value. Each of these quantification methods may be chosen depending on the UI and the screens being used at the MRI system and the control system such that to help the user making efficiently and quickly a decision on the control of the MRI system.

According to one embodiment, steps b) to e) being performed for multiple performance parameters, the providing comprising: for each performance parameter of the multiple performance parameters determining a delta value as the difference between the current value of the performance parameter and the reference value, displaying a multi-dimensional space such that each point in the space is determined by the delta values of a current setting; displaying the points in the displayed space such that a center point at the center of the space represents the reference setting.

The process of scanning and choosing the right scanning parameters is time-consuming, especially for less-trained users, and a non-ideal choice may lead to non-ideal diagnostic information or unnecessary re-scans. In addition, the time required to select and tune the acquisition parameters is especially relevant in emergency situations, where often minutes or seconds count to perform a diagnosis and choose a treatment. This embodiment may enable the user based on the displayed information to take quickly choice of the parameters and thus a decision to perform the scanning based on the chosen parameters. Thus it may be important to display to the operator, in real-time, how the drift has fared against the baselined/reference protocol so that the operator can understand whether the drift was necessary or not, and would hence help to avoid unnecessary drifts in subsequent scans. This may then enable operators to do efficient scans and thus would save a lot of effort and time, and would hence enable hospitals to scan patients in time which may be important in emergency cases.

The control system may for example be configured to select the GUI from a plurality of GUIs that are configured to display respective settings. In one example, the GUI may be displayed such that the center point of the space is at a predefined maximum distance dc of the center of the display device e.g. dc=0, dc=2cm or dc<=10cm. By performing a display of the data in a single GUI with reference to the center of the display device, the data of the current settings is near the user's current visual focus of attention and thus it may be guaranteed to be seen immediately compared to an arbitrary placement on other places of the display device. For example, points associated with the setting in the GUI may be linked by an interactive trail that allow to revert to any previous setting by clicking on the point in the trail that corresponds to that previous setting.

In case of two performance parameters, the space may be a two-dimensional Cartesian system that has two axis that divide the plane into quadrants, each bounded by two half-axes quadrant. The origin of the Cartesian system represents the reference setting. In this case the process of displaying of step d) may be referred to as quadrantization. In case of three performance parameters, the space may for example be a cube.

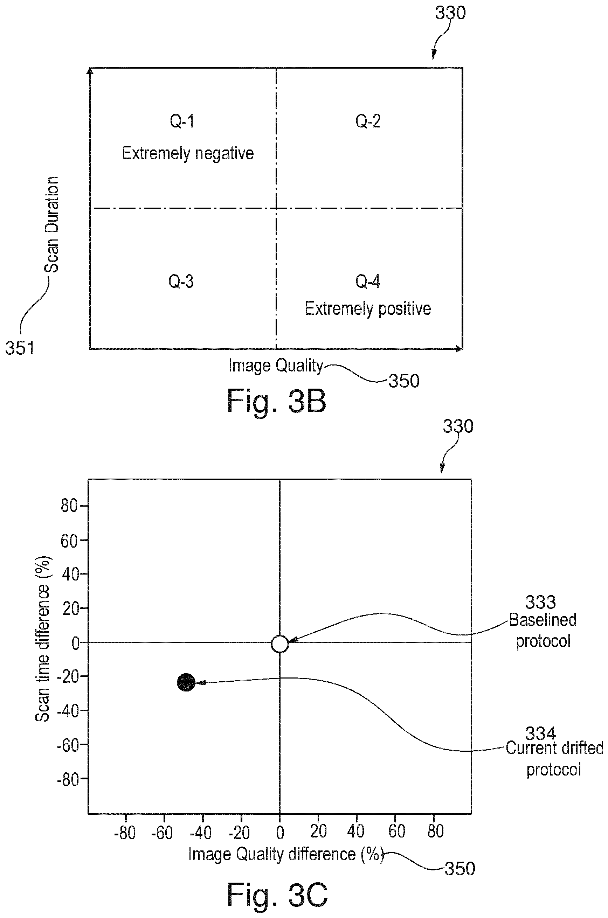

According to one embodiment, the received selection is a selection of the point that has the most optimal delta values e.g. among other displayed points. This may enable an accurate and optimal control of the MRI system. For example, the most optimal values may correspond to a point in quadrant Q-4 of Figure 3B (and the worst delta values maybe the ones in quadrant Q-1). Q-4 is the best quadrant. For example, for a setting to be in Q-4 quadrant, the scan time delta would have to be negative (as per the given formula) - indicating reduction in scan time and the values indicative of the image quality may be positive.

According to one embodiment, the evaluating of the performance parameter of the MRI system comprises: identifying acquisition parameters of the current setting that impact the performance parameter; quantifying the performance parameter using the values of the identified acquisition parameters. This embodiment may enable an accurate quantification of the performance parameters and may thus increase the performance of the MRI system.

According to one embodiment, the controlling of the MRI system further comprising creating a unique identifier for the current setting; storing the current setting in association with the unique identifier and with the current value of the performance parameter. This may enable to keep track of settings being previously used. Those stored settings may for example be used to monitor the activities performed in one or more MRI systems. For example, the reference setting may be updated or changed using the stored settings e.g. the most frequently used setting may be used as the reference setting for further acquisition of MRI data. For example, the storage may be performed in a database, wherein the database may be queried for reading the history of the used settings.

For example, when a user wants to analyze and evaluate all protocol drifts in relation to a specific reference protocol, an estimated scan time and image quality rating of the reference protocol may be retrieved from the database. Details of all drifted protocols or a subset of drifted protocols (based on a given filter) may be retrieved from the database. An iteration through the list of retrieved drifted protocols may be performed, and for each drifted protocol, scan time difference and image quality difference with respect to the reference protocol may be determined. Each drift may be quadrantized/displayed based on the scan time difference and image quality difference thus computed.

According to one embodiment, the repeating of step a) comprises receiving a selection of a setting of the stored settings, wherein the current values of the set of acquisition parameters are the values of the selected setting.

The evaluation of the performance parameter comprises estimating the performance parameter. For example, the performance parameter may be predicted using the values of the set of acquisition parameters. According to one embodiment, the performance parameter comprises one of a scan time of the acquisition of the MRI data, image quality of an image that can be reconstructed from MRI data that is obtainable by the acquisition by the MRI system, number of breath-holds, breath-hold duration and a combination thereof.

Step b) may comprise evaluation of more than one performance parameter. This may particularly be advantageous as the more performance parameters being evaluated the better the understanding and thus the decision to acquire the MRI data. For example, an estimated scan time alone may not be enough to comprehend the overall impact. At the same time, quantification of simulated images alone too may not be sufficient to comprehend the impact of the drift and justify it.

In another aspect, the invention relates to a medical imaging method for controlling a magnetic resonance imaging, MRI, system. The method comprises:

   a) determining current values of a set of acquisition parameters of a current setting of the MRI system;
   b) evaluating a performance parameter of the MRI system using the current setting, the evaluation resulting in a current value of the performance parameter;
   c) comparing the value of the performance parameter with a reference value of the performance parameter, the reference value of the performance parameter being provided for reference values of the set of acquisition parameters of a reference setting;
   d) providing data indicative of the current setting and indicative of a comparison between the current value and the reference value of the performance parameter on a user interface and further providing on the user interface data indicative of the reference setting;

e) in case of receiving a selection of one of the settings, controlling the MRI system to acquire MRI data in accordance with the received selection; otherwise and in case of receiving a change in the current setting repeating steps a) to e).

In another aspect, the invention relates to a computer program product comprising machine executable instructions for execution by a processor, wherein execution of the machine executable instructions causes the processor to the methods of any of the preceding embodiments.

It is understood that one or more of the aforementioned embodiments of the invention may be combined as long as the combined embodiments are not mutually exclusive.

## BRIEF DESCRIPTION OF THE DRAWINGS

In the following preferred embodiments of the invention will be described, by way of example only, and with reference to the drawings in which:

Fig. 1 is a schematic diagram of a control system in accordance with the present subject matter,
Fig. 2 is a flowchart of a method for controlling operation of a MRI system in accordance with an example of the present subject matter,
Fig. 3A is a flowchart of a method for adapting an imaging protocol of a MRI system in accordance with an example of the present subject matter.
Figs. 3B-3D depict a bi-dimensional space.
Fig. 4 is a block diagram of a control system in accordance with an example of the present subject matter.
Fig. 5 is a block diagram for a method for using the control system, in a product such as an MRI system.
Fig. 6 is a block diagram for a method for using the control system.
Fig. 7 shows a cross-sectional and functional view of an MRI system,
Fig. 8 is a graphical user interface in accordance with an example of the present subject matter.

## DETAILED DESCRIPTION OF THE EMBODIMENTS

In the following, like numbered elements in the figures are either similar elements or perform an equivalent function. Elements which have been discussed previously will not necessarily be discussed in later figures if the function is equivalent.

Various structures, systems and devices are schematically depicted in the figures for purposes of explanation only and so as to not obscure the present invention with details that are well known to those skilled in the art. Nevertheless, the attached figures are included to describe and explain illustrative examples of the disclosed subject matter.

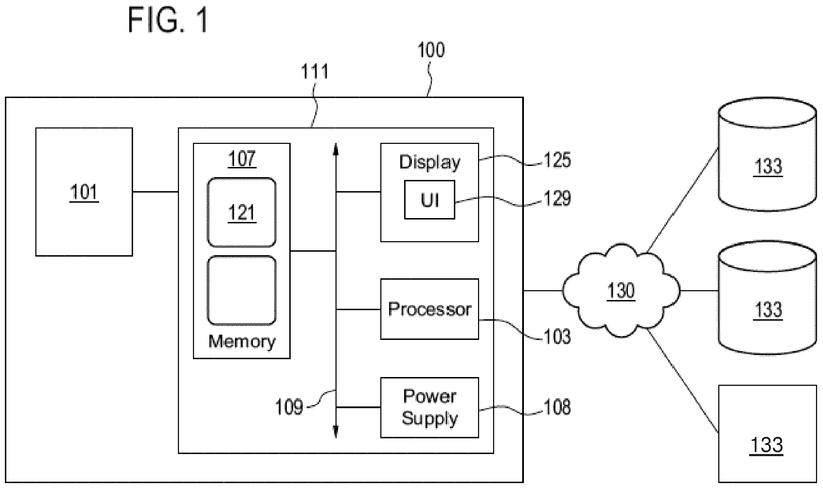

Fig. 1 is a schematic diagram of a medical analysis system 100. The medical analysis system 100 comprises a control system 111 that is configured to connect to a scanning imaging system (or acquisition component) 101. The control system 111 comprises a processor 103, a memory 107 each capable of communicating with one or more components of the medical system 100. For example, components of the control system 111 are coupled to a bidirectional system bus 109.

It will be appreciated that the methods described herein are at least partly non-interactive, and automated by way of computerized systems. For example, these methods can further be implemented in software 121, (including firmware), hardware, or a combination thereof. In exemplary embodiments, the methods described herein are implemented in software, as an executable program, and is executed by a special or general-purpose digital computer, such as a personal computer, workstation, minicomputer, or mainframe computer.

The processor 103 is a hardware device for executing software, particularly that stored in memory 107. The processor 103 can be any custom made or commercially available processor, a central processing unit (CPU), an auxiliary processor among several processors associated with the control system 111, a semiconductor based microprocessor (in the form of a microchip or chip set), a macroprocessor, or generally any device for executing software instructions. The processor 103 may control the operation of the scanning imaging system 101.

The memory 107 can include any one or combination of volatile memory elements (e.g., random access memory (RAM, such as DRAM, SRAM, SDRAM, etc.)) and nonvolatile memory elements (e.g., ROM, erasable programmable read only memory (EPROM), electronically erasable programmable read only memory (EEPROM), programmable read only memory (PROM). Note that the memory 107 can have a distributed architecture, where various components are situated remote from one another, but can be accessed by the processor 103. Memory 107 may store an instruction or data related to at least one other constituent element of the medical system 100.

The control system 111 may further comprise a display device 125 which displays characters and images and the like e.g. on a user interface 129 such as a graphical user interface. The display device 125 may comprise one or more screens e.g. multiple screens. A screen of the screens may be a touch screen.

The medical analysis system 100 may further comprise a power supply 108 for powering the medical analysis system 100. The power supply 108 may for example be a battery or an external source of power, such as electricity supplied by a standard AC outlet.

The scanning imaging system 101 may comprise at least one of MRI, CT and PET-CT imagers. The control system 111 and the scanning imaging system 101 may or may not be an integral part. In other terms, the control system 111 may or may not be external to the scanning imaging system 101.

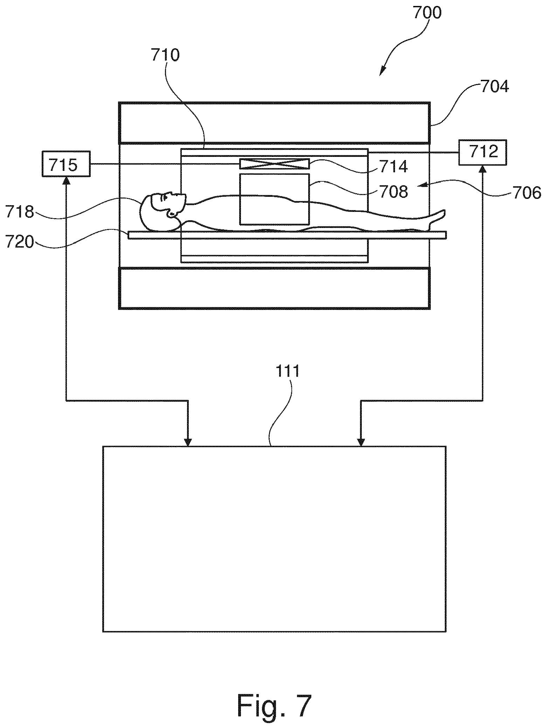

The scanning imaging system 101 comprises components that maybe controlled by the processor 103 in order to configure the scanning imaging system 101 to provide image data to the control system 111. The configuration of the scanning imaging system 101 may enable the operation of the scanning imaging system 101. The operation of the scanning imaging system 101 may for example be automatic. Figure 7 shows an example of components of the scanning imaging system 101 being an MRI system.

The connection between the control system 111 and the scanning imaging system 101 may for example comprise a BUS Ethernet connection, WAN connection, Internet connection etc.

In one example, the scanning imaging system 101 may be configured to provide output data such as images. The control system 111 may be configured to receive data such as image data from the scanning imaging system 101. For example, the processor 103 may be adapted to receive information (automatically or upon request) from the scanning imaging system 101 in a compatible digital form so that such information may be displayed on the display device 125. Such information may include operating parameters, alert notifications, and other information related to the use, operation and function of the scanning imaging system 101.

The medical analysis system 100 may be configured to communicate via a network 130 with other scanning imaging systems 131 and/or databases 133. The network 130 comprises for example a wireless local area network (WLAN) connection, WAN (Wide Area Network) connection LAN (Local Area Network) connection or a combination thereof. The databases 133 may comprise information relates to patients, scanning imaging systems, anatomies, scan geometries, scan parameters, scans etc. The databases 133 may for example comprise an EMR database comprising patients' EMR, Radiology Information System database, medical image database, PACS, Hospital Information System database and/or other databases comparing data that can be used for planning a scan geometry.

The control system 111 may be configured to connect to one or more MRI systems 101 and to control operation of the MRI systems in accordance with the present subject matter. This may enable a centralized control of imaging by multiple MRIs, which may enable consistent operations of the MRI systems. In another example, the control system 100 may be part of a MRI system and may control the MRI system in accordance with the present subject matter. This may enable a portable, independent and distributed application of the present subject matter on each MRI system.

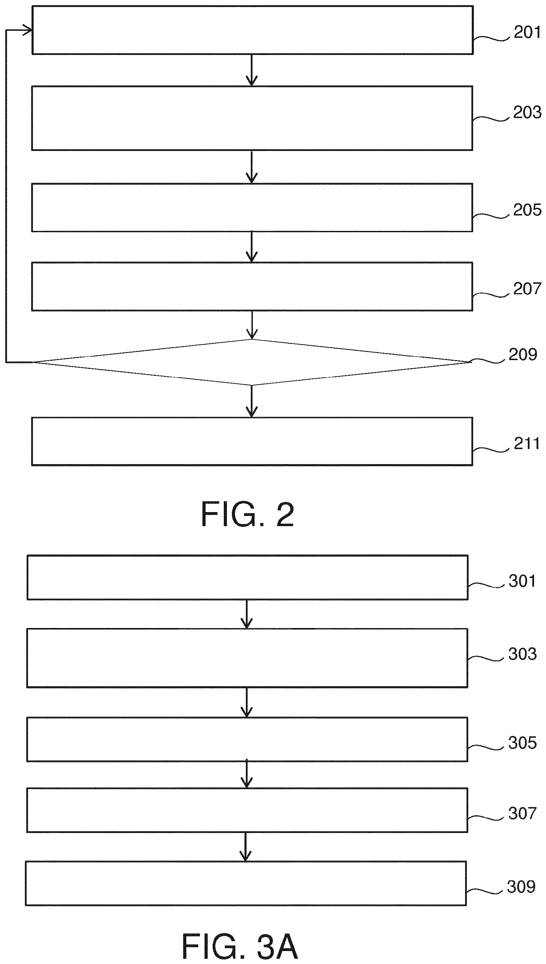

Fig. 2 is a flowchart of a method for controlling operation of an MRI system e.g. 101. The MRI system may enable to acquire MRI data in accordance with an imaging protocol. The imaging protocol or protocol refers to a set of acquisition parameters of imaging modalities to produce the images (e.g. MR images) required for an examination. The MRI system may for example be provided with a reference setting that has reference values of the set of acquisition parameters.

For magnetic resonance imaging, typically many acquisition parameters define an imaging protocol according to which the MRI system may acquire MRI data. The set of acquisition parameters may for example have respective initial values. When a new patient is arriving for an examination, an operator will have to select/maintain and/or change values of the set of acquisition parameters (resulting in an operator defined setting) in order to be adapted to the patient, the clinical question, or the preferences of a referring physician.

In step 201, a control system such as the control system 111 may be configured to determine current values of a set of acquisition parameters of the MRI system. The current values of the set of acquisition parameters define a current operator defined setting. Current values enable accurate scanning by the MRI system e.g. using non up-to-date values of the parameters may lead to sub-optimal performance of the scanning by the MRI system. For example, the current values of the set of acquisition parameters may be the values that the operator is going to use for scanning by the MRI system.

For example, the control system may be configured to determine the current values of the set of acquisition parameters after a predefined time period is lapsed. The time period may for example be the period between the time at which the operator has made a first change in a value of a parameter of the set of acquisition parameters and a predefined end point of time e.g. after 10 minutes of the first change, the operator may be assumed as having finished the changes he or she made and the control system may use the values immediately after that end point of time as the current values. This may for example particularly be advantageous in a a research set-up e.g. if for some reason there is no activity at all for a long time after the parameters have been changed.

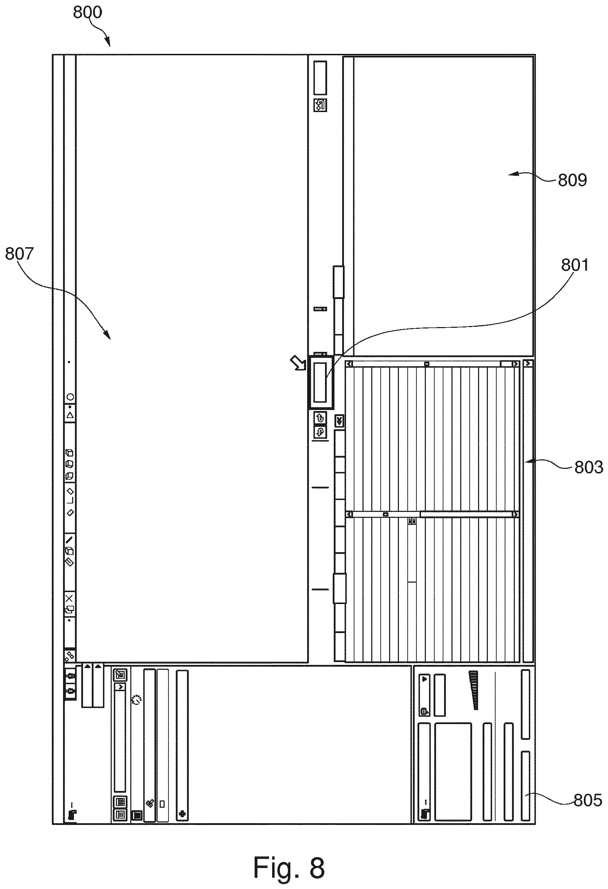

In another example, the control system may prompt the operator for an input indicting whether the operator has finished the choice of the values of the set of acquisition parameters. Upon receiving that input from the operator, the control system may determine the current values of the set of acquisition parameters. In a further example, the control system may receive an input indicating that that the current operator defined setting is changed. For example, the operator may click on the *Accept* button 801 of the graphical user interface as shown in Fig. 8.

The control system may further be configured to store the reference values of the set of acquisition parameters. In one example, the initial values may be the reference values. This may be advantageous as the operator may make an appropriate change or selection of values of the set of acquisition parameters which may improve the performance of the scanning performed by the MRI system based on the current values of the set of acquisition parameters.

The control system may evaluate (e.g. to provide an estimated value) in step 203 of at least one performance parameter $p_i$, where i can be equal to or higher than 1, of the MRI system using the current values of the set of acquisition parameters. The control system may for example estimate the value of the at least one performance parameter using a model or function describing the performance parameter as function of at least part of the set of acquisition parameters. For example, the control system may identify acquisition parameters of the set of acquisition parameters that impact the performance parameter and may quantify the performance parameter using the values of the identified acquisition parameters. For example, the performance parameter may be the total scan time of the MRI system. The total scan time may be the time required to collect all data needed to generate an image. The scan time may be related to the used pulse sequence and dependent on a group of parameters like e.g., repetition time (TR), Matrix, number of signal averages (NSA), TSE- or EPI factor and flip angle. For example, the total scan time for a standard spin echo or gradient echo sequence may be the number of repetitions times the scan time per repetition (means the product of repetition time (TR), number of phase encoding steps, and NSA) e.g. the above model may be defined as *"the number of repetitions × the scan time per repetition"*.

In one example, the performance parameter may be an image quality of magnetic resonance imaging. The image quality may be dependent of acquisition parameters such as image resolution (matrix, field of view, slice thickness), contrast (TE, TR), signal to noise ratio (bandwidth, signal averaging) and lack of artefacts. These parameters may be used to quantify the image quality associated with the set of acquisition parameters.

The control system may compare in step 205 the value of the performance parameter with a reference value of the performance parameter. Using the reference value of the performance parameter may enable a consistent evaluation of the performance of the MRI system which may increase the production efficiency of the MRI system e.g. not comparing with a reference value may lead to repeated unnecessary scanning by the MRI system. For example, the control system may further be configured to store the reference value of the performance parameter in association with the reference values of the set of acquisition parameters. The reference value may be evaluated (e.g. similarly as described in step 303 or using real data) using the reference values of the set of acquisition parameters. In one example, the comparison comprises the computation of the relative difference between the estimated value of the performance parameter and the reference value of the performance parameter as follows:

$$\text{delta } p_i(\%) = \left(\frac{\text{estimated value of } p_i - \text{reference value of } p_i}{\text{reference value of } p_i}\right) \times 100.$$

Steps 203 and 205 may be performed for each performance parameter $p_i$ of the performance parameters. For example, if the at least one performance parameter comprises two performance parameters p1 and p2, this may result in two differences delta $p_1$ and delta $p_2$.

The control system may display in step 207 on a graphical user interface (on the GUI 129 of the control system and/or on the GUI of the MRI system) data indicative of the current operator defined setting and the reference setting and further indicative of a comparison between the respective values of the performance parameter. The GUI may for example be launched or displayed. The data may indicate the operator defined setting in association with respective delta $p_i$. For example, if the current values were determined only once, this means there is a single operator defined setting SET1 in addition to the reference setting SETREF, and if the at least one performance parameter comprises two performance parameters p1 and p2, the data displayed on the GUI may indicate delta $p_1$ and delta $p_2$ and SET1 and SETREF. For example, a bi-dimensional space e.g. comprising quadrants as shown in Figs 3B-D may be displayed. The horizontal axis of the space may be associated with values of delta $p_1$ of the performance parameter p1 and the vertical axis may be associated with values of delta $p_2$ of the performance parameter p2. The centre point (0,0) of the bi-dimensional space may represent the reference setting. Another point (delta $p_1$, delta $p_2$) of SET1 may be displayed in the multi-dimensional space (e.g. as shown in Fig. 3C). The distance between the two points, namely centre point and the point (delta $p_1$, delta $p_2$), may indicate how good the current values compared to reference values immediately. This displaying may enable a guided human-machine interaction process which assists the operator in performing the scanning by the MRI system. In particular, this may enable a real-time comprehensive impact assessment of impact of multiple performance parameters p1 and p2, such as scan time and image quality, combined together in relation to the baselined/reference setting so that the operator can clearly assess the comprehensive impact as compared to the baselined/reference protocol before starting the scan of the MRI system. This may then cater to all customer segments, such as first users who prioritize image quality for deciding on MRI scanning, second users who prioritize reduction in scan time for deciding on MRI scanning so as to accommodate more patients, and optimizers who want to get the best of both as much as possible for deciding on MRI scanning.

The control system may determine (inquiry step 209) if a selection of one of the settings on the GUI is received by the control system. If so, step 211 may be performed, otherwise steps 201-207 may be repeated. If there is no selection, the initial values of the set of acquisition parameters may become the values of the set of acquisition parameters of the last iteration that have not been selected. In step 211, the control system may control the scanning by the MRI system in accordance with the received selection. For example, the values of the selected set of acquisition parameter e.g. either setting SET1 or SETREF may be used to control the MRI system to perform the scanning using that selected setting.

Fig,3A is a flowchart of a method for adapting an imaging protocol of a MRI system in accordance with an example of the present subject matter. A protocol drift refers to a change in a protocol. A drifted protocol refers to a changed protocol. The drifted protocol (operator defined setting) may be the protocol or setting that an operator is willing to use to perform an MR acquisition. The protocol may be referred to as a setting which is defined as described above by the values of the set of acquisition parameters.

For every protocol drift made by an operator resulting in a current operator defined setting e.g., once the operator has made the parameter changes and is ready to scan, an estimation of the scan time and image quality (IQ) maybe performed in step 301. In order to do so, the parameters that impact the image quality may be identified and based on the values of those identified parameters, the image quality may be quantified. At least part of the present method may be performed in real time. Since this is done in real-time, as soon as the operator has modified the acquisition parameters and is ready to scan, the quantification of the image quality may be done purely based on the parameter values, and not on an actual image. This may particularly be advantageous since this estimation is a relative assessment in relation to a baselined/reference setting, and the same quantification mechanism is used for both settings.

The estimated scan time of the current operator defined setting is compared in step 303 with the estimated scan time of the baselined/reference setting and the difference in scan duration may be determined. The impact to the estimated image quality in relation to the baselined /reference protocol may be determined in step 305. This may for example be performed based on the parameters modified and their values. The image quality of the current operator defined setting and of the baselined/reference setting may be rated in step 307 on a ten-point Likert scale based on the quantification of the image quality done using the acquisition parameter values. A rating on a pre-determined scale may help the operator to understand how the image quality of the drifted protocol has fared and may take scanning decisions based on that. The rated image qualities may be compared with the reference rated image quality e.g. their relative difference may be determined.

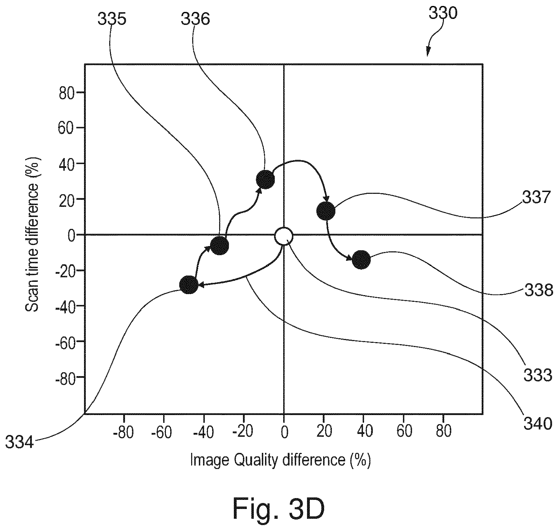

The comparison of both performance parameters scan time and rated image quality may be displayed in step 309 in accordance with the quadrantization. For example, the drift may be quadrantized based on the impact to image quality and scan time as compared to the baselined/reference setting. Based on the impact to image quality and scan duration, every protocol drift (or every operator defined setting) would fall into one of a four quadrants Q-1, Q-2, Q-3 and Q-4 depicted in Fig.3B of a two dimensional space 330. The quadrantization may be done in real-time and may be displayed to the operator as depicted in Fig. 3C. The origin of the quadrant i.e., the point (0, 0) 333 represents the baselined/reference setting and the point 334 represents the operator defined setting. This may enable the operator to clearly and immediately realize the comprehensive impact of the protocol drift that he or she has just made. If the operator is not satisfied with the result and makes further changes to the current operator defined setting 334, each further change may result in a respective operator defined setting, and for each further operator defined setting, steps 301-309 may be repeated which result in their respective points 335 to 338 as shown in Fig. 3D. Every such drift may be illustrated or depicted as an interactive trail 340 across the quadrants in real-time, as depicted in Fig.3D. The operator may click on any point 333 to 338 on this drift trail (including the origin point which represents the baselined /reference setting) to easily and very quickly revert to any previous state that was more desirable in terms of required image quality and acceptable scan time. In other words, upon clicking on any point 333-338 on this trail 340, all protocol parameter values would be automatically reverted back to the values corresponding to the setting of that selected point.

Figs. 3B-3D depict a two-dimensional space 330 or system such as a graph that is structured to comprise quadrants Q-1, Q-2, Q-3 and Q-4. The two-dimensional space has two axes. The horizontal axis comprises values 350 that represent the image quality parameter. The vertical axis comprises values 351 that represent the scan time parameter. Each point 333 to 338 represents a respective setting. Each point of the points 333 to 338 has the values 350 and 351 of the two performance parameters as evaluated for the setting represented by said point. The points 333 to 338 are connected by a trail 340 to indicate the order (in time) of the settings as defined by an operator. The operator could also focus (hover) on any point 333 to 338 in to see the following details of the corresponding drift in a popup window:

- absolute value of the estimated scan time for current drifted protocol
- absolute value of the estimated scan time for baselined/reference protocol
- difference percent of scan time as compared to the baselined/reference protocol
- image quality rating on a ten-point Likert scale for current drifted protocol
- image quality rating on a ten-point Likert scale for baselined/reference protocol

- difference percent of the image quality rating as compared to the baselined/reference protocol.

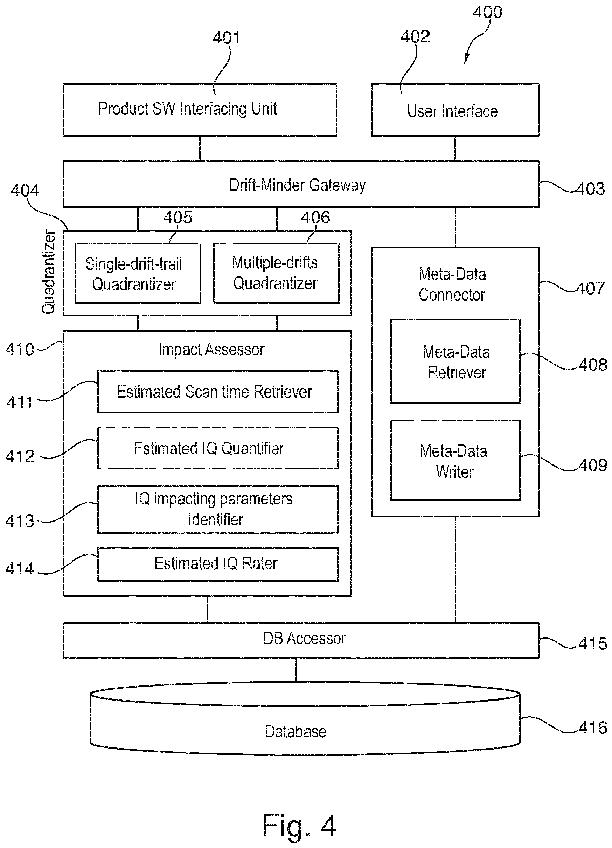

Fig. 4 is a block diagram of a control system 400 (also named Drift Minder) in accordance with an example of the present subject matter.

The control system 400 comprises a product software interfacing unit 401 and a user interface 402. The control system 400 further comprises a gateway 403 that is connected to a quadrantizer 404 and a meta-data connector 407. The quadrantizer 404 comprises a single-drift-trail quadrantizer 405 and a multiple-drifts quadrantizer 406. The single-drift-trail quadrantizer 405 may enable to process in accordance with the present subject matter the current protocol obtained or selected by a single user. The multiple-drifts quadrantizer 406 may enable to process in accordance with the present subject matter the current settings obtained by different users or the settings for similar exams (for example, Brain W/o W exams) done on different patients. The meta-data connector 407 comprises meta-data retriever 408 and meta-data writer 409. The quadrantizer 404 is connected to an impact accessor 410. The impact assessor 410 comprises an estimated scan time retriever 411, an estimated IQ quantifier 412, an IQ impacting parameters identifier 413 and an estimated IQ rater 414. The impact accessor 410 and meta-data connector 407 are connected to a database (DB) accessor 415 that enables access to a database 416.

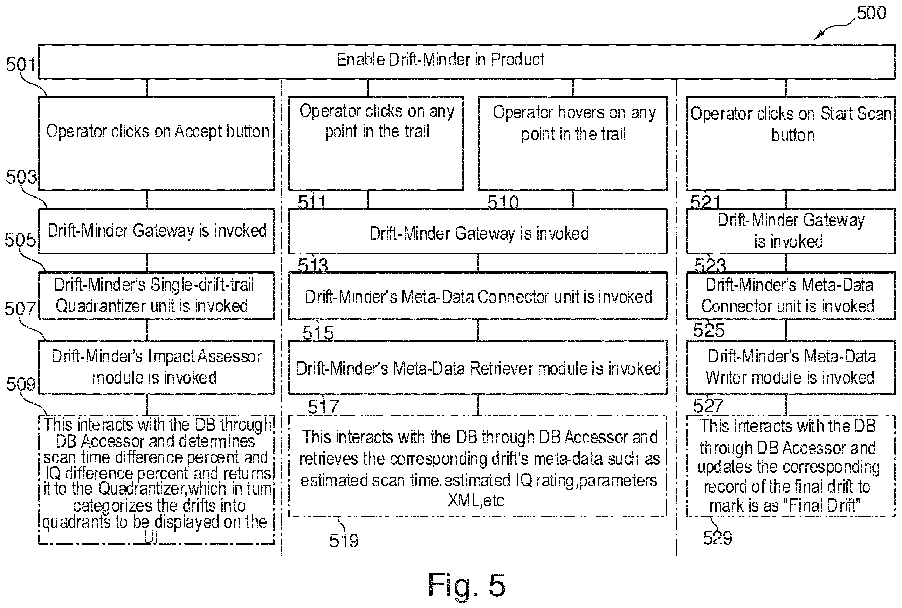

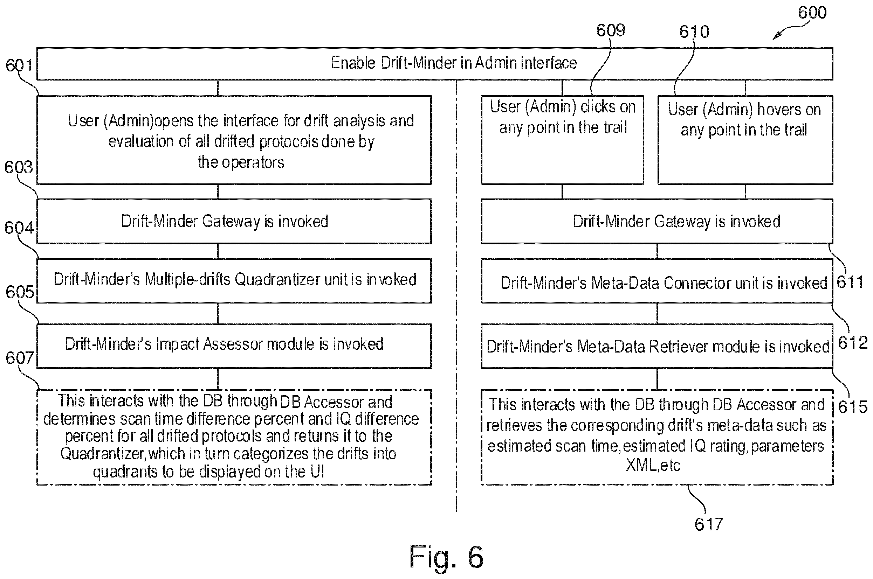

The operation of the control system 400 may be described with reference to Figs. 5 and 6.

Fig. 5 is a block diagram for a method 500 for using the control system e.g. 400, in a product such as an MRI system.

In step 501, the control system 400 may receive e.g. via user interface 402 or product software interfacing unit 401 a selection of a current imaging protocol to be used for imaging by the MRI system. For example, an operator may click an *Accept* button e.g. 801 of Fig. 8 to indicate that he or she has made the choice the current values of the set of acquisition parameters for the current protocol. The current protocol may be referred to as drifted or changed protocol. In response to that click, the gateway 403 may be invoked in step 503, which may induce the invocation in step 505 of the single-drift-trail quadrantizer 405. The single-drift-trail quadrantizer 405 may use or invoke in step 507 impact accessor 410 in order to perform the following. The impact assessor 410 may retrieve or determine using the estimated scan time retriever 411 an estimated scan time of the current protocol, the estimated scan time of the baselined / reference protocol from the database 416. The impact accessor 410 may use the estimated scan time retriever 411 to compute the difference between the estimated scan times in percent using the following formula: scan time difference (%) =

$$\left(\frac{\text{estimated scan time of current protocol} - \text{estimated scan time of reference protocol}}{\text{estimated scan time of reference protocol}}\right) \times 100.$$ The impact accessor 410 may use the IQ impacting parameters identifier 413 to identify protocol parameters that impact image quality. The impact assessor 410 may use the estimated IQ quantifier 412 to quantify estimated image quality of the current protocol based on the values of the parameters that impact image quality. Based on the quantification value, the impact assessor 410 may rate using the estimated IQ rater 414 the image quality of the current protocol on a ten-point Likert scale and may retrieve using the estimated IQ rater 414 image quality rating of the baselined / reference protocol from the database 416. The impact assessor 410 may use the estimated IQ rater 414 to compute the difference in image quality rating in percent using the following formula: IQ difference (%) =

$$\left(\frac{\text{estimated IQ of current protocol} - \text{estimated IQ of reference protocol}}{\text{estimated IQ of reference protocol}}\right) \times 100.$$ Using the resulting differences, the single-drift-trail quadrantizer 405 may quadrantize the drift based on the computed scan time difference and image quality difference. The single-drift-trail quadrantizer 405 may display the drift quadrantization on an MR console (end-product UI) of the MRI system. The single-drift-trail quadrantizer 405 may create a unique identifier for the drift associated with the current protocol and may store the state of the drift such that it can be re-created at any point of time in the future. The table structure used for storing may be the following:

| Drifted Protocol UID | Parent protocol UID | Protocol parameters XML | Estimated scan time | Estimated Image Quality Quantification value | Estimated Image Quality Rating | Is final drift |
|---|---|---|---|---|---|---|
| | | | | | | |

Steps 505 and 507 may use DB accesses of step 509 for accessing information in the database 416.

The described steps 501-509 maybe performed for every subsequent drift of the protocol until the scan is actually done, and displays an interactive trail across the drift quadrants.

Upon hover (step 510) on any point in the trail, it displays the corresponding details.

Upon clicking (step 511) on any point in the interactive trail or performing step 510, the gateway 403 is invoked (step 513) which in turn invokes (step 515) the meta-data connector 407. The meta-data connector 407 uses or invokes (step 517) the meta-data retriever 408 to retrieve (step 519) the drift state from the database 416. In case of a selection as in step 511 all the protocol parameters are populated to the values corresponding to the drifted protocol associated with the selected point. In case of a hover as in step 510, the details corresponding to the point may be displayed.

The operator may then use the current protocol, based on their comparison that is displayed to the operator, to perform scanning by the MRI system. For that, the operator may click (step 521) on a *Start* button indicating that he or she has chosen the current protocol (that he or she initially accepted by clicking on the *Accept* button). Upon clicking on the *Start* button, the gateway 403 is invoked (step 523) which in turn invokes (step 525) the meta-data connector 407. The meta-data connector 407 uses or invokes (step 527) the meta-data writer 409 to update (step 529) the corresponding record that is stored in the above table. This may enable that every time a scan is done after a protocol drift, the corresponding drift record is updated in the database such that it is marked as the final drift (by setting the last column of the above table depicted as True).

Fig. 6 is a block diagram for a method 600 for using the control system e.g. 400, as a central protocol management (CPM) system. In this example, the control system may support drift assessment and comparison both in relation to a specific reference protocol as well as in relation to average scan time and image quality of all similar protocols.

For example, when a user (admin) wants to analyze and evaluate all protocol drifts in relation to average scan time and image quality of all similar protocols, the user may open (step 601) an interface for drift analysis and evaluation of all drifted protocols done by the operators. The opening of the user interface may happen by launching or starting an application program that execute at least part of the present method e.g. of Figure 2 or 3.

Upon opening the interface, the gateway 403 is invoked (step 603) which in turn invokes (step 604) the multiple-drifts quadrantizer 406. The multiple-drifts quadrantizer 406 may use or invoke in step 605 impact assessor 410 so that the impact assessor 410 may retrieve (step 607) details of all drifted protocols or a subset of drifted protocols from the database 416 e.g. the subset may be obtained by applying a given filter. The multiple-drifts quadrantizer 406 may determine the average value of estimated scan times for the retrieved drifted protocols. The multiple-drifts quadrantizer 406 may further determine the average quantification value of estimated image qualities for the retrieved drifted protocols. Based on the quantification value so computed, the IQ rating may be determined. The multiple-drifts quadrantizer 406 may iterate through the list of drifted protocols, and for each drifted protocol, it determines scan time difference and image quality difference with respect to the average scan time and image quality rating of average IQ quantification value using the formulae depicted with reference to Figure 5. The multiple-drifts quadrantizer 406 may quadrantize each drift based on the scan time difference and image quality difference thus computed. The quadrantization may result in a quadrant such as the quadrants of Figures 3B-D displayed on the interface 129.

The user may click (609) on a point of the displayed quadrant or may hover (610) on a point in the quadrant. In response to step 609 or 610, the gateway 403 is invoked (step 611) which in turn invokes (step 613) the meta-data connector 407. The meta-data connector 407 uses or invokes (step 615) the meta-data retriever 408 to retrieve (step 619) the drift state from the database 416. In case of selection as in step 609 all the protocol parameters are populated to the values corresponding to the drifted protocol associated with the selected point. In case of a hover, the details corresponding to the point may be displayed.

Fig. 7 illustrates a magnetic resonance imaging system 700 as an example of the medical system 100. The magnetic resonance imaging system 700 comprises a magnet 704. The magnet 704 is a superconducting cylindrical type magnet with a bore 706 in it. The use of different types of magnets is also possible; for instance, it is also possible to use both a split cylindrical magnet and a so called open magnet or a sealed magnet. A split cylindrical magnet is similar to a standard cylindrical magnet, except that the cryostat has been split into two sections to allow access to the iso-plane of the magnet. Such magnets may for instance be used in conjunction with charged particle beam therapy. An open magnet has two magnet sections, one above the other with a space in-between that is large enough to receive a subject 718 to be imaged, the arrangement of the two sections area similar to that of a Helmholtz coil. Inside the cryostat of the cylindrical magnet there is a collection of superconducting coils. Within the bore 706 of the cylindrical magnet 704 there is an imaging zone or volume or anatomy 708 where the magnetic field is strong and uniform enough to perform magnetic resonance imaging.

Within the bore 706 of the magnet there is also a set of magnetic field gradient coils 710 which is used during acquisition of magnetic resonance data to spatially encode magnetic spins of a target volume within the imaging volume or examination volume 708 of the magnet 704. The magnetic field gradient coils 710 are connected to a magnetic field gradient coil power supply 712. The magnetic field gradient coils 710 are intended to be representative. Typically, magnetic field gradient coils 710 contain three separate sets of coils for the encoding in three orthogonal spatial directions. A magnetic field gradient power supply supplies current to the magnetic field gradient coils. The current supplied to the magnetic field gradient coils 710 is controlled as a function of time and may be ramped or pulsed.

MRI system 700 further comprises an RF coil 714 at the subject 718 and adjacent to the examination volume 708 for generating RF excitation pulses. The RF coil 714 may include for example a set of surface coils or other specialized RF coils. The RF coil 714 may be used alternately for transmission of RF pulses as well as for reception of magnetic resonance signals e.g., the RF coil 714 may be implemented as a transmit array coil comprising a plurality of RF transmit coils. The RF coil 714 is connected to one or more RF amplifiers 715.

The magnetic field gradient coil power supply 712 and the RF amplifier 715 are connected to a hardware interface of control system 111. The memory 107 of control system 111 may for example comprise a control module. The control module contains computer-executable code which enables the processor 103 to control the operation and function of the magnetic resonance imaging system 700. It also enables the basic operations of the magnetic resonance imaging system 700 such as the acquisition of magnetic resonance data.

Fig. 8 shows an example GUI (e.g. used in the displaying step d)) of the present method. The GUI 800 maybe a GUI that may be displayed in a display system of the MRI system. The GUI 800 comprises values of the set of acquisition parameters 803 that defines a protocol or setting of the MRI system. For example, the quadrants of Figs. 3B, 3C or 3D maybe displayed in the area 807 or area 809 of the GUI 800. If for example, the user selects one of the points 333-338 of Fig 3D, the current setting 803 would have the values of the set of acquisition parameters of a setting that is represented by said selected point. The GUI 800 further comprises an *Accept* button 801 that an operator may use to accept the current setting 803 e.g. this may inform the control system 111 so that the step 201 may be performed. The GUI 800 further comprises a *start* button 805 that the operator may use to start the scanning using the current setting.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, microcode, etc.) or an embodiment combining software and hardware aspects that may all generally be referred to herein as a 'circuit', 'module' or 'system'. Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, a data may be retrieved over a modem, over the internet, or over a local area network. Computer executable code embodied on a computer readable medium may be transmitted using any appropriate medium, including but not limited to wireless, wireline, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

A 'computer memory' or 'memory' is an example of a computer-readable storage medium. A computer memory is any memory which is directly accessible to a processor. A 'computer storage' or 'storage' is a further example of a computer-readable storage medium. A computer storage is any non-volatile computer-readable storage medium. In some embodiments computer storage may also be computer memory or vice versa.

A 'processor' as used herein encompasses an electronic component which is able to execute a program or machine executable instruction or computer executable code. References to the computing device comprising 'a processor' should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the 'C' programming language or similar programming languages and compiled into machine executable instructions. In some instances, the computer executable code may be in the form of a high-level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It will be understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device'. A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, gear sticks, steering wheel, pedals, wired glove, dance pad, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bistable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word 'comprising' does not exclude other elements or steps, and the indefinite article 'a' or 'an' does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

LIST OF REFERENCE NUMERALS

| 100 | medical system |
| 101 | scanning imaging system |
| 103 | processor |
| 107 | memory |
| 108 | power supply |
| 109 | bus |
| 111 | control system |
| 121 | software |
| 125 | display |
| 129 | user interface |
| 133 | databases |
| 201-309 | method steps |
| 330 | bi-dimensional space or graph |
| 333-338 | points |
| 340 | trail |
| 400 | control system |
| 401 | software interfacing unit |
| 402 | User interface |
| 403 | gateway |
| 404 | quadrantizer |
| 405 | single-drift-trail quadrantizer |
| 406 | multiple-drifts quadrantizer |
| 407 | meta-data connector |
| 408 | meta-data retriever |
| 409 | meta-data writer |
| 410 | impact assessor |
| 411 | estimated scan time retriever |
| 412 | estimated IQ quantifier |
| 413 | IQ impacting parameters identifier |
| 414 | estimated IQ rater |
| 415 | DB accessor |
| 416 | database |
| 501-617 | method steps |
| 700 | magnetic resonance imaging system |
| 704 | magnet |
| 706 | bore of magnet |
| 708 | imaging zone |
| 710 | magnetic field gradient coils |
| 712 | magnetic field gradient coil power supply |
| 714 | radio-frequency coil |
| 715 | RF amplifier |
| 718 | subject |
| 800 | GUI |
| 801 | accept button |
| 803 | setting |
| 805 | start acquisition button. |

**Claims**

1. A control system (111) for a magnetic resonance imaging, MRI, system (700), the control system (111) comprising at least one processor (103) and at least one memory (107) comprising computer program code (121), wherein execution of the computer program code (121) by the processor (103) causes the control system (111) to at least perform:

   a) determining current values of a set of acquisition parameters of a current setting of the MRI system (700);
   b) evaluating a performance parameter of the MRI system (700) using the current setting, the evaluation resulting in a current value of the performance parameter;
   c) comparing the value of the performance parameter with a reference value of the performance parameter, the reference value of the performance parameter being provided for reference values of the set of acquisition parameters of a reference setting;
   d) providing data indicative of the current setting and indicative of a comparison between the current value and the reference value of the performance parameter on a user interface and further providing on the user interface data indicative of the reference setting;
   e) in case of receiving a selection of one of the settings, controlling the MRI system (700) to acquire MRI data in accordance with the received selection; otherwise and in case of receiving a change in the current setting repeating steps a) to e).

2. The control system of claim 1, executing steps a) -e) during operation of the MRI system.

3. The control system of any of the preceding claims, wherein execution of the computer program code by the processor further causes the control system to: retrieve from a database the reference value; compute the difference between values of the performance parameter of the current setting and the reference setting; wherein the providing of the comparison comprises displaying the computed difference.

4. The control system of any of the preceding claims, steps b) to e) being performed for multiple performance parameters, the providing comprising: for each performance parameter of the multiple performance parameters determining a delta value as the difference between the current value of the performance parameter and the reference value, displaying a multi-dimensional space such that each point in the space is determined by the delta values of a current setting; displaying the points in the displayed space such that a center point at the center of the space represents the reference setting.

5. The control system of claim 3, the received selection being a selection of the point that has the most optimal delta values.

6. The control system of any of the preceding claims, the evaluating of the performance parameter of the MRI system comprising: identifying acquisition parameters of the current setting that impact the performance parameter; quantifying the performance parameter using the values of the identified acquisition parameters.

7. The control system of any of the preceding claims, the controlling of the MRI system further comprising creating a unique identifier for the current setting; storing the current setting in association with the unique identifier and with the current value of the performance parameter.

8. The control system of claim 7, wherein the repeating of step a) comprises receiving a selection of a setting of the stored settings, wherein the current values of the set of acquisition parameters are the values of the selected setting.

9. The control system of any of the preceding claims, the performance parameter comprises one of a scan time of the acquisition of the MRI data, breath-hold duration, and image quality of an image that has been reconstructed from MRI data that is obtained by the acquisition by the MRI system.

10. An MRI system (700) comprising the control system (111) of any of the preceding claims.

11. A medical imaging method for controlling a magnetic resonance imaging, MRI, system, the method comprising:

   a) determining current values of a set of acquisition parameters of a current setting of the MRI system;
   b) evaluating a performance parameter of the MRI system using the current setting, the evaluation resulting in a current value of the performance parameter;

c) comparing the value of the performance parameter with a reference value of the performance parameter, the reference value of the performance parameter being provided for reference values of the set of acquisition parameters of a reference setting;

d) providing data indicative of the current setting and indicative of a comparison between the current value and the reference value of the performance parameter on a user interface and further providing on the user interface data indicative of the reference setting;

e) in case of receiving a selection of one of the settings, controlling the MRI system to acquire MRI data in accordance with the received selection; otherwise and in case of receiving a change in the current setting repeating steps a) to e).

12. A computer program product comprising machine executable instructions for execution by a processor, wherein execution of the machine executable instructions causes the processor to perform at least part of the method of any of the preceding claims.

FIG. 1

FIG. 2

FIG. 3A

330

Fig. 3B

330

Fig. 3C

Fig. 3D

Fig. 4

500

| Enable Drift-Minder in Product | | | |
|---|---|---|---|

501

| Operator clicks on Accept button | Operator clicks on any point in the trail | Operator hovers on any point in the trail | Operator clicks on Start Scan button |
|---|---|---|---|

503

511 510 521

| Drift-Minder Gateway is invoked | Drift-Minder Gateway is invoked | | Drift-Minder Gateway is invoked |
|---|---|---|---|

505

513 523

| Drift-Minder's Single-drift-trail Quadrantizer unit is invoked | Drift-Minder's Meta-Data Connector unit is invoked | | Drift-Minder's Meta-Data Connector unit is invoked |
|---|---|---|---|

507

515 525

| Drift-Minder's Impact Assessor module is invoked | Drift-Minder's Meta-Data Retriever module is invoked | | Drift-Minder's Meta-Data Writer module is invoked |
|---|---|---|---|

509

517 527

| This interacts with the DB through DB Accessor and determines scan time difference percent and IQ difference percent and returns it to the Quadrantizer,which in turn categorizes the drifts into quadrants to be displayed on the UI | This interacts with the DB through DB Accessor and retrieves the corresponding drift's meta-data such as estimated scan time,estimated IQ rating,parameters XML,etc | This interacts with the DB through DB Accessor and updates the corresponding record of the final drift to mark is as "Final Drift" |
|---|---|---|

519 529

## Fig. 5

600

609   610

| 601 | Enable Drift-Minder in Admin interface |

| 603 | User (Admin)opens the interface for drift analysis and evaluation of all drifted protocols done by the operators | | User (Admin) clicks on any point in the trail | User (Admin) hovers on any point in the trail |

| 604 | Drift-Minder Gateway is invoked | | Drift-Minder Gateway is invoked |

| 605 | Drift-Minder's Multiple-drifts Quadrantizer unit is invoked | | Drift-Minder's Meta-Data Connector unit is invoked | 611 |

| 607 | Drift-Minder's Impact Assessor module is invoked | | Drift-Minder's Meta-Data Retriever module is invoked | 612 |

This interacts with the DB through DB Accessor and determines scan time difference percent and IQ difference percent for all drifted protocols and returns it to the Quadrantizer, which in turn categorizes the drifts into quadrants to be displayed on the UI

This interacts with the DB through DB Accessor and retrieves the corresponding drift's meta-data such as estimated scan time, estimated IQ rating, parameters XML,etc   615

617

## Fig. 6

Fig. 7

Fig. 8

Europäisches
Patentamt

European
Patent Office

Office européen
des brevets

# EUROPEAN SEARCH REPORT

Application Number

EP 19 17 5285

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 6 687 527 B1 (WU DEE H [US] ET AL) 3 February 2004 (2004-02-03) <br> * figures 2A,2B,3,6 * <br> * column 7, line 20 - column 12, line 14 * <br> * column 17, line 45 - column 19, line 5 * <br> * column 19, line 63 - column 20, line 63 * <br> ----- | 1-3,5-8, 10-12<br><br>9 | INV. G01R33/54 |
| X | US 2015/216440 A1 (SENEGAS JULIEN [DE] ET AL) 6 August 2015 (2015-08-06) <br> * figures 3,4,5 * <br> * paragraph [0035] - paragraph [0041] * <br> ----- | 1-3,5-8, 10-12 | |
| X | US 2019/120920 A1 (HARDER TIM PHILIPP [DE] ET AL) 25 April 2019 (2019-04-25) <br> * figures 3,4 * <br> * paragraph [0013] * <br> * paragraph [0097] - paragraph [0112] * <br> ----- | 1-12 | |
| X | US 2011/113376 A1 (SUZUKI KENJI [JP] ET AL) 12 May 2011 (2011-05-12) <br> * figures 2,10-14 * <br> * paragraph [0040] - paragraph [0044] * <br> * paragraph [0061] - paragraph [0078] * <br> ----- | 1-3,5-12 | TECHNICAL FIELDS SEARCHED (IPC)<br><br>G01R |

The present search report has been drawn up for all claims

| Place of search | Date of completion of the search | Examiner |
|---|---|---|
| Munich | 28 November 2019 | Durst, Markus |

## ANNEX TO THE EUROPEAN SEARCH REPORT
## ON EUROPEAN PATENT APPLICATION NO.

EP 19 17 5285

This annex lists the patent family members relating to the patent documents cited in the above-mentioned European search report.
The members are as contained in the European Patent Office EDP file on
The European Patent Office is in no way liable for these particulars which are merely given for the purpose of information.

28-11-2019

| Patent document cited in search report | | Publication date | Patent family member(s) | | Publication date |
|---|---|---|---|---|---|
| US 6687527 | B1 | 03-02-2004 | EP | 1423722 A1 | 02-06-2004 |
| | | | JP | 2005501624 A | 20-01-2005 |
| | | | US | 6687527 B1 | 03-02-2004 |
| | | | WO | 03021284 A1 | 13-03-2003 |
| US 2015216440 | A1 | 06-08-2015 | BR | 112015000875 A2 | 27-06-2017 |
| | | | CN | 104583796 A | 29-04-2015 |
| | | | EP | 2872914 A2 | 20-05-2015 |
| | | | JP | 6305401 B2 | 04-04-2018 |
| | | | JP | 2015522370 A | 06-08-2015 |
| | | | RU | 2015104982 A | 10-09-2016 |
| | | | US | 2015216440 A1 | 06-08-2015 |
| | | | WO | 2014013390 A2 | 23-01-2014 |
| US 2019120920 | A1 | 25-04-2019 | CN | 109073723 A | 21-12-2018 |
| | | | EP | 3446139 A1 | 27-02-2019 |
| | | | JP | 2019520863 A | 25-07-2019 |
| | | | US | 2019120920 A1 | 25-04-2019 |
| | | | WO | 2017182369 A1 | 26-10-2017 |
| US 2011113376 | A1 | 12-05-2011 | CN | 102058409 A | 18-05-2011 |
| | | | CN | 105125214 A | 09-12-2015 |
| | | | JP | 5635254 B2 | 03-12-2014 |
| | | | JP | 2011098128 A | 19-05-2011 |
| | | | US | 2011113376 A1 | 12-05-2011 |
| | | | US | 2017030987 A1 | 02-02-2017 |

EPO FORM P0459

For more details about this annex : see Official Journal of the European Patent Office, No. 12/82